# EUROPEAN PATENT APPLICATION

(11) **EP 4 657 508 A2**
(43) Date of publication of application: **03.12.2025**
(21) Application number: 25177540.9
(22) Date of filing: 20.05.2025
(51) Int. Cl.: H01L 21/56, H01L 23/31, H01L 23/495

(54) **DESTRESSING STRUCTURE FOR SEMICONDUCTOR PACKAGES AND METHOD OF MANUFACTURING THE SAME**

(30) Priority: 30.05.2024 US 202418679248
(71) Applicant: STMicroelectronics International N.V., 1228 Plan-les-Ouates, Geneva (CH)
(72) Inventor: PAUL, Indrajit, 88677 Markdorf (DE); YOO, Inpil, 82008 Unterhaching (DE)
(74) Representative: Casalonga

(57) **Abstract**

A semiconductor device or package includes a destressing structure to prevent or reduce the likelihood of mechanical defects propagating within the semiconductor device or package by mitigating or reducing stresses and strains. Various layers, structures, or components within or part of the semiconductor device or package have Coefficients of Thermal Expansion (CTEs) that are different from each other causing them to expand and contract by different amounts when exposed to changes in temperature or thermal energy. A destressing structure of the semiconductor device or package includes a groove, trench, or recess within the molding compound to mitigate or reduce stresses and strains to prevent or reduce the likelihood of mechanical defects propagating within the semiconductor device or package.

## Description

### BACKGROUND

### Technical Field

The present disclosure is directed to a destressing structure of a semiconductor package that prevents or reduces stresses and strains within the semiconductor package, and a method of manufacturing the same.

### Description of the Related Art

Semiconductor packages of various types generally include a molding compound, which may be a resin material, an epoxy material, or some other suitable non-conductive material that encases conductive structures and layers that form electrical connections to and from a die or provides a thermal dissipation pathway to and from a heat sink. The molding compound generally has a first Coefficient of Thermal Energy (CTE) and the conductive structures generally have a second CTE that is different from the first CTE. The differences in these CTEs between the molding compound and the conductive structures results in the molding compound and the conductive structures expanding and contracting by different amounts when exposed to changes in temperature or thermal energy *(i.e.,* increases in temperature or decreases in temperature). The differences in thermal expansion and contraction between the molding compound and conductive structures result in stresses and strains increases at various locations between the molding compound and the conductive structures. For example, these locations may be located near edges or sidewalls of the conductive structures in physical contact or in close proximity to the molding compound. These locations at which there is relatively high stress and strain when the molding compound and the conductive structures are exposed to changes in temperature or thermal energy increases the likelihood of or causes mechanical defects to propagate along these edges and sidewalls. These mechanical defects generally will increase the likelihood of or cause the semiconductor packages to fail early within their useful lifespan or increase the likelihood of or cause the semiconductor packages to be manufactured outside of tolerance such that the semiconductor packages become waste.

### BRIEF SUMMARY

The present disclosure is directed to providing one or more embodiments of a destressing structure that is formed within a molding compound to reduce stresses and strains that propagate within a molding compound, within a conductive structure, or between the molding compound and the conductive structure. For example, in at least one embodiment, a semiconductor package includes a conductive structure that is within a molding compound. The molding compound includes a surface and the conductive structure is exposed from the surface of the molding compound. The conductive structure includes one or more sidewalls that are in physical contact with the molding compound and that are covered by the molding compound.

In this at least one embodiment, a destressing structure extends fully or partially around the conductive structure to reduce stresses and strains that occur at locations at which the molding compound and the conductive structure contact each other. The destressing structure includes a groove, recess, or trench that extends into the surface of the molding compound and extends fully or partially around the conductive structure. The groove, recess, or trench provides clearance for flexibility of the molding compound in contact with or in close proximity to the conductive structure when the molding compound and the conductive structure of the semiconductor package are exposed to changes in temperature or thermal energy *(i.e.,* increases or decreases in temperature). For example, when the molding compound and the conductive structure expand due to an increase in temperature or thermal energy, the groove, recess, or trench allows for the molding compound and the conductive structure to deform (*e.g*., elastic deformation) to reduce stresses and strains at locations at which the conductive structure is in contact with or in close proximity to the molding compound. Alternatively, when the molding compound and the conductive structure contract due to an increase in temperature or thermal energy, the groove, recess, or trench allows for the conductive structure to deform (*e.g*., elastic deformation) to reduce stresses and strains at locations at which the conductive structure is in contact with or in close proximity to the molding compound.

### BRIEF DESCRIPTION OF THE SEVERAL VIEWS OF THE DRAWINGS

For a better understanding of the embodiments, reference will now be made by way of example to the accompanying drawings. In the drawings, identical reference numbers identify the same or similar elements or acts unless the context indicates otherwise. The sizes and relative proportions of the elements in the drawings are not necessarily drawn to scale. For example, some of these elements may be enlarged and positioned to improve drawing legibility.
Figure 1A is a perspective view of a semiconductor package;
Figure 1B is a top side view of the semiconductor package;
Figure 1C is a cross-sectional view of the semiconductor package taken along line 1C-1C as shown in Figure 1B;
Figure 1D is a cross-sectional, perspective view of section 1D-1D of the semiconductor package as shown in Figure 1B;
Figure 1E is a stress map of section 1D-1D of the semiconductor package as shown in Figure 1B;
Figure 2A is a perspective view of an embodiment of a semiconductor package of the present disclosure;
Figure 2B is a top side view of the embodiment of the semiconductor package of the present disclosure as shown in Figure 2A;
Figure 2C is a cross-sectional view of the embodiment of the semiconductor package of the present disclosure as shown in Figures 2A and 2B and taken along line 2C-2C as shown in Figure 1B;
Figure 2D is a cross-sectional, perspective view of the embodiment of the semiconductor package of the present disclosure as shown in Figures 2A-2C and taken about section 2D-2D as shown in Figure 2B;
Figure 2E is a stress map of section 2D-2D of the embodiment of the semiconductor package of the present disclosure as shown in Figure 2D;
Figure 3A is a perspective view of an alternative embodiment of a semiconductor package of the present disclosure;
Figure 3B is a top side view of the alternative embodiment of the semiconductor package of the present disclosure as shown in Figure 3A;
Figure 3C is a cross-sectional view of the alternative embodiment of the semiconductor package of the present disclosure as shown in Figures 3A and 3B and taken along line 3C-3C as shown in Figure 3B;
Figure 3D is a cross-sectional, perspective view of the alternative embodiment of the semiconductor package of the present disclosure as shown in Figures 3A-3C and taken about section 3D-3D as shown in Figure 3B;
Figure 4A is a perspective view of another alternative embodiment of a semiconductor package of the present disclosure;
Figure 4B is a top side view of the another alternative embodiment of the semiconductor package of the present disclosure as shown in Figure 4A;
Figure 4C is a cross-sectional view of the another alternative embodiment of the semiconductor package of the present disclosure as shown in Figures 4A and 4B and taken along line 4C-4C as shown in Figure 4B;
Figure 4D is a cross-sectional, perspective view of the another alternative embodiment of the semiconductor package of the present disclosure as shown in Figures 4A-4C and taken about section 4D-4D as shown in Figure 4B;
Figure 5 is a flowchart of an embodiment of a method of manufacturing a destressing structure of the embodiment of the semiconductor package as shown in Figures 2A-2D of the present disclosure;
Figures 6A and 6B are cross-sectional side views of respective steps of the method of manufacturing as shown in Figure 5;
Figure 7 is a flowchart of an alternative embodiment of a method of manufacturing a destressing structure of the embodiment of the semiconductor package as shown in Figures 2A-2D of the present disclosure;
Figures 8A and 8B are cross-sectional side views of respective steps of the method of manufacturing as shown in Figure 7; and
Figure 9 is a top view of yet another alternative embodiment of a semiconductor package of the present disclosure.

### DETAILED DESCRIPTION

In the following description, certain details are set forth in order to provide a thorough understanding of various embodiments of devices, methods and articles. However, one of skill in the art will understand that other embodiments may be practiced without these details. In other instances, well-known structures and methods associated with, for example, molding compounds layers or structures, conductive layers or structures, semiconductor fabrication processes, etc., have not been shown or described in detail in some figures to avoid unnecessarily obscuring descriptions of the embodiments.

Unless the context requires otherwise, throughout the specification and claims which follow, the word "comprise" and variations thereof, such as "comprising," and "comprises," are to be construed in an open, inclusive sense, that is, as "including, but not limited to."

Reference throughout this specification to "one embodiment," or "an embodiment" means that a particular feature, structure or characteristic described in connection with the embodiment is included in at least one embodiment. Thus, the appearances of the phrases "in one embodiment," or "in an embodiment" in various places throughout this specification are not necessarily referring to the same embodiment, or to all embodiments. Furthermore, the particular features, structures, or characteristics may be combined in any suitable manner in one or more embodiments to obtain further embodiments.

The headings are provided for convenience only, and do not interpret the scope or meaning of this disclosure or the claims.

The sizes and relative positions of elements in the drawings are not necessarily drawn to scale. For example, the shapes of various elements and angles may not be drawn to scale, and some of these elements may be enlarged and positioned to improve drawing legibility.

The use of "transverse" means that a surface, a sidewall, or similar or like structure or feature is at an angle with respect to another respective surface, sidewall, or similar or like respective structure or feature. For example, if a first surface is transverse to a first sidewall, the first surface may be at an angle that is equal to 25-degrees, 35-degrees, 45-degrees, 75-degrees, 90-degrees, 120-degrees, and so forth.

Generally, semiconductor packages are formed by fully or partially encasing or embedding various conductive structures or layers, one or more respective electronic components *(i.e.,* semiconductor dice, integrated circuits, or some other suitable electronic component), and other suitable structures and components to form the semiconductor package. These various structures, layers, and components partially or fully embedded within the molding compound generally each have respective Coefficients of Thermal Expansion (CTE) that differ from a CTE of the molding compound. These differences in CTEs between the various structures, layers, and components within the molding compound relative to the molding compound causes the various structures, layers, and components to expand and contract by different amounts relative to each other and the molding compound when the semiconductor packages are exposed to changes in temperatures or thermal energy *(i.e.,* increases and decreases in temperature). The differing amounts of expansion and contraction between the various structures, layers, components, and the molding compound results in stresses and strains propagating within the various structures, layers, components, and the molding compound. When these stresses and strains increase, the likelihood of mechanical defects propagating within the semiconductor package increases. For example, types of mechanical defects include cracking within the structures, layers, components or the molding compound, delamination between the structures, layers, components, or the molding compound, or some other similar or like type of mechanical defect that may propagate or occur within the structures, layers, components, or the molding compound. When these mechanical defects occur within the semiconductor packages, the mechanical defects generally will cause the semiconductor packages to function in a less efficient manner or completely stop working altogether resulting in the semiconductor package becoming defective.

In view of the above discussion, the present disclosure is directed to providing one or more embodiments of a destressing structure that is formed within a molding compound to reduce stresses and strains that propagate within a molding compound, within a conductive structure, or between the molding compound and the conductive structure to reduce the likelihood of or prevent mechanical defects from propagating within the molding compound, the conductive structure, or between the molding compound and the conductive structure. For example, in at least one embodiment, a semiconductor package includes a conductive structure that is within a molding compound. The molding compound includes a surface and the conductive structure is exposed from the surface of the molding compound. The conductive structure includes one or more sidewalls that are in physical contact with the molding compound and that are covered by the molding compound.

In this at least one embodiment, a destressing structure extends fully or partially around the conductive structure to reduce stresses and strains that occur at locations at which the molding compound and the conductive structure contact each other. The destressing structure includes a groove, recess, or trench that extends into the surface of the molding compound and extends fully or partially around the conductive structure. The groove, recess, or trench provides clearance for flexibility of the molding compound in contact with or in close proximity to the conductive structure when the molding compound and the conductive structure of the semiconductor package are exposed to changes in temperature or thermal energy *(i.e.,* increases or decreases in temperature). For example, when the molding compound and the conductive structure expand due to an increase in temperature or thermal energy, the groove, recess, or trench allows for the molding compound and the conductive structure to deform (e.g., elastic deformation) to reduce stresses and strains at locations at which the conductive structure is in contact with or in close proximity to the molding compound. Alternatively, when the molding compound and the conductive structure contract due to an increase in temperature or thermal energy, the groove, recess, or trench allows for the conductive structure to deform (e.g., elastic deformation) to reduce stresses and strains at locations at which the conductive structure is in contact with or in close proximity to the molding compound.

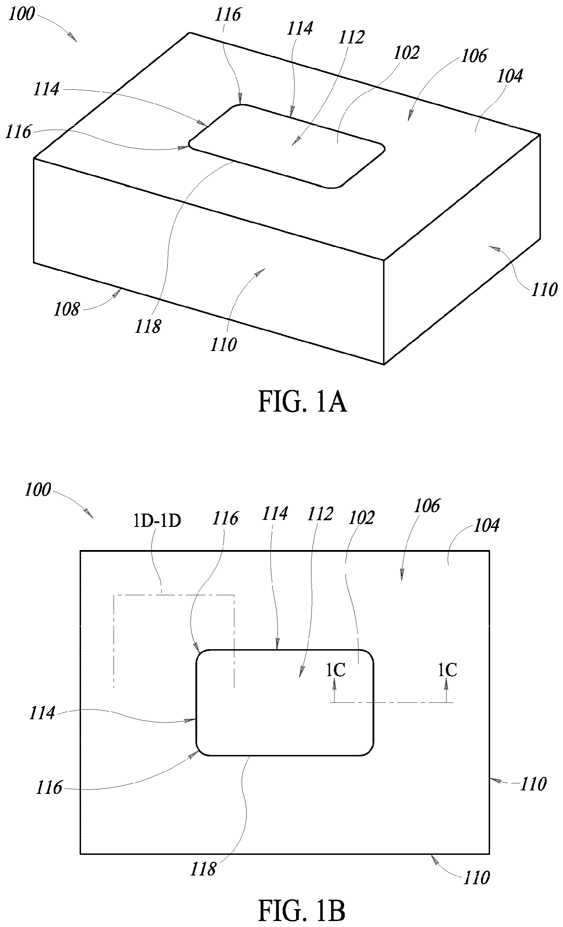

Figure 1A is a perspective view of a semiconductor package 100 including a conductive structure 102 within a molding compound 104. The semiconductor package 100 does not include a respective destressing structure. Figure 1B is a top side view of the semiconductor package 100 as shown in Figure 1A.

The molding compound 104 includes a first surface 106, a second surface 108 opposite to the first surface 106, and one or more sidewalls 110 that are transverse to the first and second surfaces 106, 108 and that extend from the first surface 106 to the second surface 108. The molding compound 104 may be a resin, an epoxy, or some other similar or like type of non-conductive material capable of being utilized to enclose various conductive layers, active components, or passive components of the semiconductor package 100. The molding compound 104 has a first Coefficient of Thermal Energy (CTE).

The conductive structure 102 includes a third surface 112 exposed from the first surface 106 of the molding compound 104. The conductive structure 102 may be a heat sink, a contact pad, an electrical connection structure along an electrical pathway to and from an active or passive component within the molding compound 104 of the semiconductor package 100, or some other similar or like type of conductive structure within the semiconductor package 100. While not completely visible in Figure 1A, the conductive structure 102 includes one or more sidewalls 114 that are transverse to the third surface 112 and are covered by the molding compound 104. One or more corners 116 of the conductive structure 102 are present between respective sidewalls of the one or more sidewalls 114 of the conductive structure 102. An edge 118 of the conductive structure 102 extends around the third surface 112 of the conductive structure 102. The edge 118 extends along the one or more sidewalls 114 of the conductive structure 102 and along the one or more corners 116 of the conductive structure 102.

The conductive structure 102 is made of a conductive material. For example, the conductive structure 102 may be made of a copper material, a copper-alloy material, a gold material, a gold-alloy material, a silver material, a silver-alloy material, or some other similar or like type of conductive material suitable for the conductive structure 102 within the semiconductor package 100. The conductive structure 102 has a second CTE that is different from the first CTE.

As the molding compound 104 has the first CTE that is different from the second CTE of the conductive structure 102, the molding compound 104 and the conductive structure 102 expand and contract by different amounts when exposed to changes in temperature or thermal energy. These changes in temperature or thermal energy are increases or decreases in temperature or thermal energy that may be a result of increases and decreases in temperature within an external environment outside the semiconductor package 100. Alternatively, these changes in temperature or thermal energy are increase or decreases in temperature or thermal energy that may be a result of the semiconductor package being utilized and operating at max capacity.

In view of the discussion earlier herein, when the conductive structure 102 and the molding compound 104 expand and contract by different amounts stresses and strains increase within the conductive structure 102 and the molding compound 104. When these stresses and strains increase, the likelihood of mechanical defects propagating within the semiconductor package increases. For example, types of mechanical defects include cracking within the conductive structure 102 or the molding compound 104, delamination between the conductive structure 102 and the molding compound 104, or some other similar or like type of mechanical defect that may propagate or occur within the conductive structure 102, the molding compound 104, or other structures and components within the semiconductor package 100. When these mechanical defects occur within the semiconductor package 100, the mechanical defects generally will cause the semiconductor package 100 to function in a less efficient manner or completely stop working altogether resulting in the semiconductor package 100 becoming defective and having to be replaced.

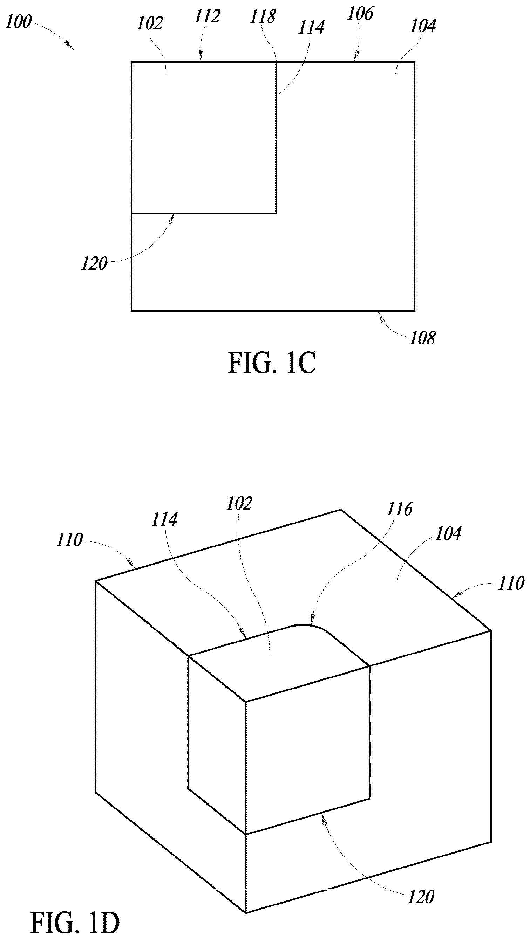

Figure 1C is a cross-sectional side view of the semiconductor package 100 as shown in Figure 1B. As shown in Figure 1C, the conductive structure 102 further includes a fourth surface 120 that is opposite to the third surface 112 of the conductive structure 102. As shown in Figure 1C, the conductive structure 102 terminates within the molding compound 104 at the fourth surface 120. Although no other layers, which may be conductive or non-conductive, components, or structures are shown in Figure 1C, it will be readily appreciated that other layers, which may be conductive or non-conductive, components, or structures may be within the molding compound 104. However, for simplicity and ease of understanding of the present disclosure, these additional details are not illustrated herein.

Figure 1D is a cross-sectional, perspective view of section 1D-1D of the semiconductor package 100 as shown in Figure 1B. As shown in Figure 1D, the one or more sidewalls 114 of the conductive structure 102 are covered by the molding compound 104.

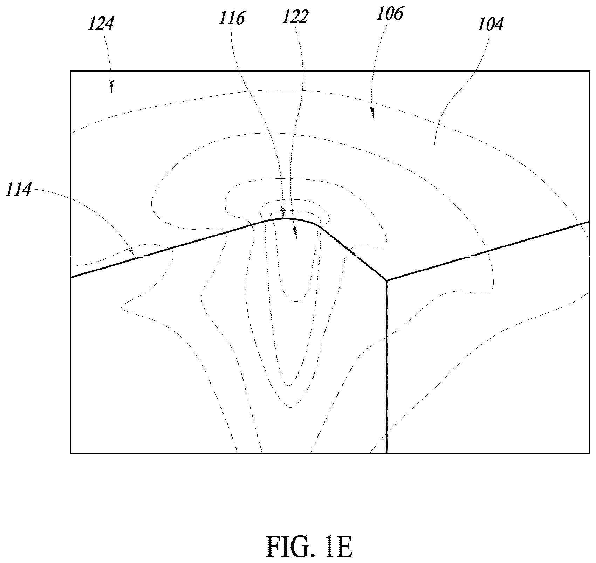

Figure 1E is a stress and strain map of section 1D-1D of the semiconductor package 100 as shown in Figure 1B with the conductive structure 102 hidden for ease of visibility of the stress and strain map of the molding compound 104. The stress and stain map is representative of when the semiconductor package 100 is exposed to an increase in temperature or thermal energy. As the temperature increases, the molding compound 104, which has the first CTE, and the conductive structure 102, which has the second CTE that is different from the first CTE, expands by different amounts. This expansion by different amounts results in stresses and strains reaching a maximum at a respective corner of the one or more corners 116 of the conductive structure 102 at or in close proximity to the edge 118. This maximum stress and strain is readily visible by a location 122 as shown in Figure 1E. As one moves away from the respective corner of the one or more corners 116, the stresses and strains decrease as shown in the stress and strain map in Figure 1E. For example, the stress and strain at another location 124 is less than the maximum stress and strain at the location 122 as shown in Figure 1E.

In view of the location 122 having the maximum stress and strain when exposed to the increase in temperature or thermal energy, the likelihood of mechanical defects (*e*.*g*., cracking of the molding compound 104 or conductive structure 102 at or in close proximity to the respective corner of the plurality of corners 116 and the edge 118, delamination of the molding compound 104 from the conductive structure 102 at or in close proximity to the respective corner of the plurality of corners 116 and the edge 118, or some other suitable or like type of mechanical defects within the semiconductor package 100) propagating at the location 122 is higher relative to a mechanical defect propagating at the another location 124 where the stress and strain is less than the location 122 at which the stress and strain is at its maximum. The location 122 at which the maximum stress and strain occurs is located at the respective corner of the one or more corners 116 and the first surface 106 of the molding compound 104. The present disclosure is directed to providing one or more embodiments of a destressing structure or structures to prevent or reduce the likelihood of mechanical defects by mitigating or relocating a location of maximum stress and strain between an interface between the conductive structure 102 and the molding compound 104.

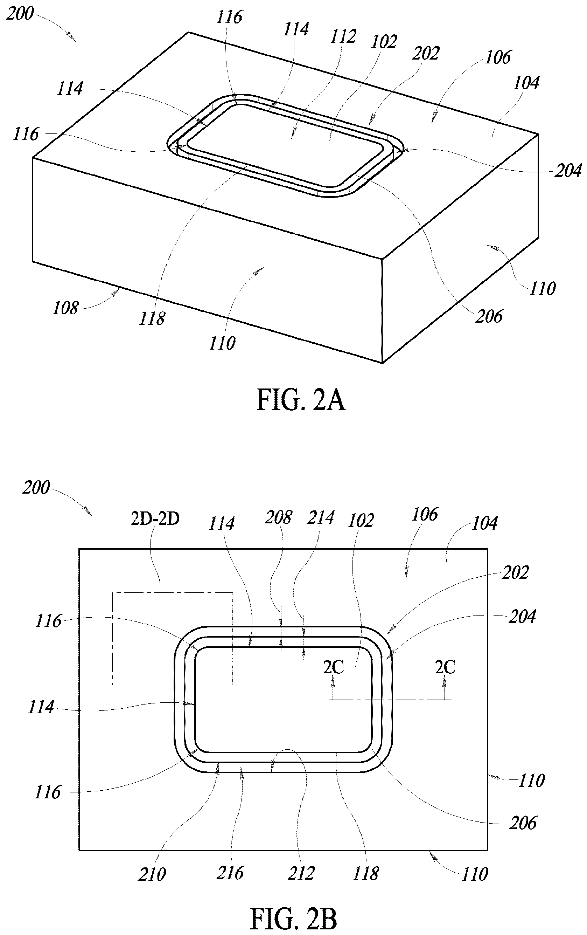

Figure 2A is a perspective view of an embodiment of a semiconductor package 200 of the present disclosure. Figure 2B is a top view of the embodiment of the semiconductor package of the present disclosure as shown in Figure 2A.

The semiconductor package 200 includes several of the same or similar features as the semiconductor package 100, and, therefore, these same or similar features between the semiconductor package 100 and the semiconductor package 200 have been provided with the same or similar reference numerals in the semiconductor package 200. For simplicity and brevity's sake of the present disclosure, the details of these same or similar features in the semiconductor package 200 relative to the semiconductor package 100 are not necessarily reproduced herein.

Unlike the semiconductor package 100 as shown in Figures 1A-1E, the semiconductor package 200 includes a destressing structure 202. A groove 204 of the destressing structure 202 extends into the first surface 106 of the molding compound 104. The groove 204 is laterally offset from the edge 118 of the conductive structure 102. In this embodiment of the semiconductor package 200 as shown in Figure 2A, the groove 204 extends continuously and completely around the third surface 112 of the conductive structure 102. A portion 206 of the molding compound 104 is on the one or more sidewalls 114 and the one or more corners 116 of the conductive structure 102. The portion 206 is disposed between the groove 204 and the one or more sidewalls 114 and the one or more corners 116 of the conductive structure 102.

The groove 204 includes a first dimension 208 that extends from a first groove sidewall 210 of the molding compound 104 that delimits the groove 204 to a second groove sidewall 212 of the molding compound 104 that delimits the groove 204. The first groove sidewall 210 is closer to the conductive structure 102 than the second groove sidewall 212. In at least some embodiments of the semiconductor package 200, the first dimension 208 is within a range of 0.5 mm (millimeters) to 3 mm (millimeters), or is equal to the upper or lower end of this range.

The portion 206 has a second dimension 214 that extends from the first groove sidewall 210 to a respective sidewall of the one or more sidewalls 114 of the conductive structure 102. The second dimension 214 may be equal to, may be greater than, or may be less than the first dimension 208.

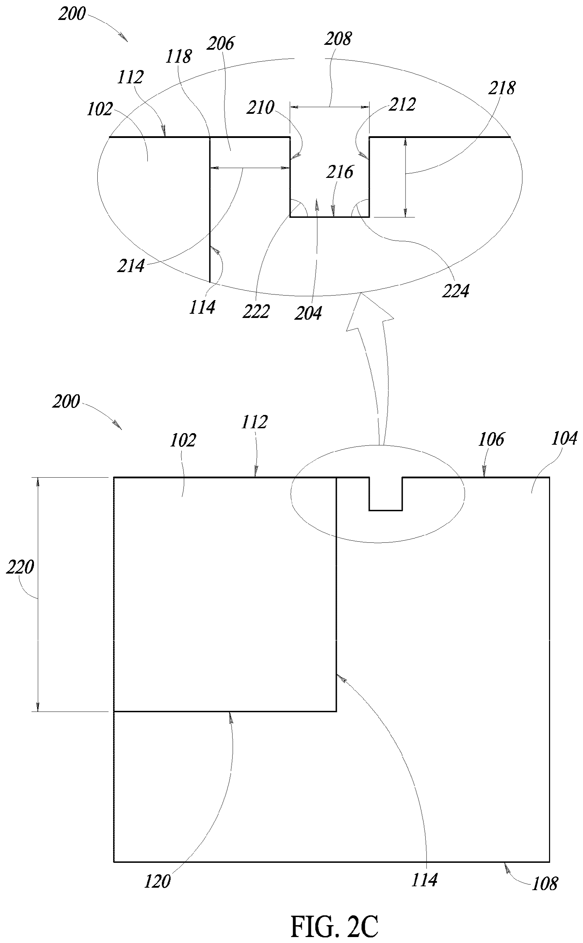

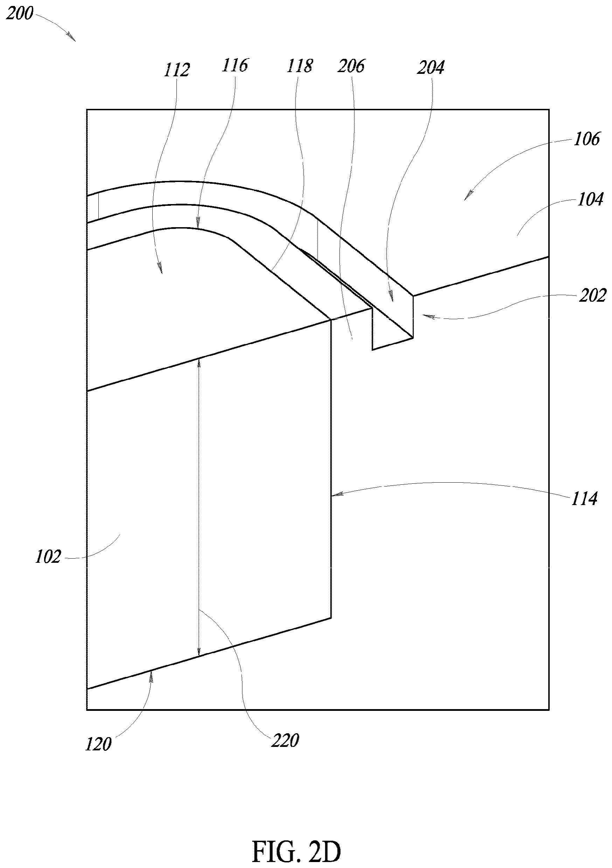

Figure 2C is a cross-sectional view of the embodiment of the semiconductor package 200 taken along line 2C-2C as shown in Figure 2B. Figure 2D is a cross-sectional, perspective view of the embodiment of the semiconductor package of the present disclosure as shown in Figures 2A-2C and taken about section 2D-2D as shown in Figure 2B.

As shown in Figure 2C, the groove 204 terminates at an end groove surface 216 of the molding compound 104, and the end groove surface 216 of the molding compound 104 is recessed relative to the first surface 106 of the molding compound 104. The groove 204 further includes a third dimension 218 that extends from the first surface 106 of the molding compound 104 to the end groove surface 216 of the molding compound 104. In at least some embodiments of the semiconductor package 200, the third dimension is within a range of 0.75 mm (millimeters) to 4.5 mm (millimeters), or is equal to the upper or lower end of this range

As shown in Figure 2C, the conductive structure 102 includes a fourth dimension 220 that extends from the third surface 112 of the conductive structure 102 to the fourth surface 120 of the conductive structure 102. In this embodiment of the semiconductor package 200 as shown in Figure 2C, the third dimension 218 is less than the fourth dimension 220. However, in some alternative embodiments, it is possible that the third dimension 218 is equal to the fourth dimension 220 or the third dimension is greater than the fourth dimension 220. The first dimension 208, the second dimension 214, and the third dimension 218 are adjusted based on an environment in which the semiconductor package 200 is to be utilized, adjusted based on a functionality of the semiconductor package 200, or adjusted based on similar or like factors that will prevent or reduce the likelihood of mechanical defects propagating within the semiconductor package 200 due to a CTE mismatch between the conductive structure 102 and the molding compound 104.

A first angle 222 is between the first groove sidewall 210 and the end groove surface 216, and a second angle 224 is between the second groove sidewall 212 and the end groove surface 216. In this embodiment as shown in Figure 2C, the first angle 222 and the second angle 224 are substantially equal to 90 degrees such that the first groove sidewall 210 and the second groove sidewall 212 are both perpendicular or orthogonal to the end groove surface 216. In some alternative embodiments of the semiconductor package 200, the first angle 222 and the second angle 224 may be different from each other such that the first groove sidewall 210 and the second groove sidewall 212 are at different angles relative to the groove end surface 216. The first angle 222 and the second angle 224 are adjusted based on an environment in which the semiconductor package 200 is to be utilized, adjusted based on a functionality of the semiconductor package 200, or adjusted based on similar or like factors that will prevent or reduce the likelihood of mechanical defects propagating within the semiconductor package 200 due to a CTE mismatch between the conductive structure 102 and the molding compound 104. In some other embodiments, the first angle 222 and the second angle 224 are greater than 90-degrees.

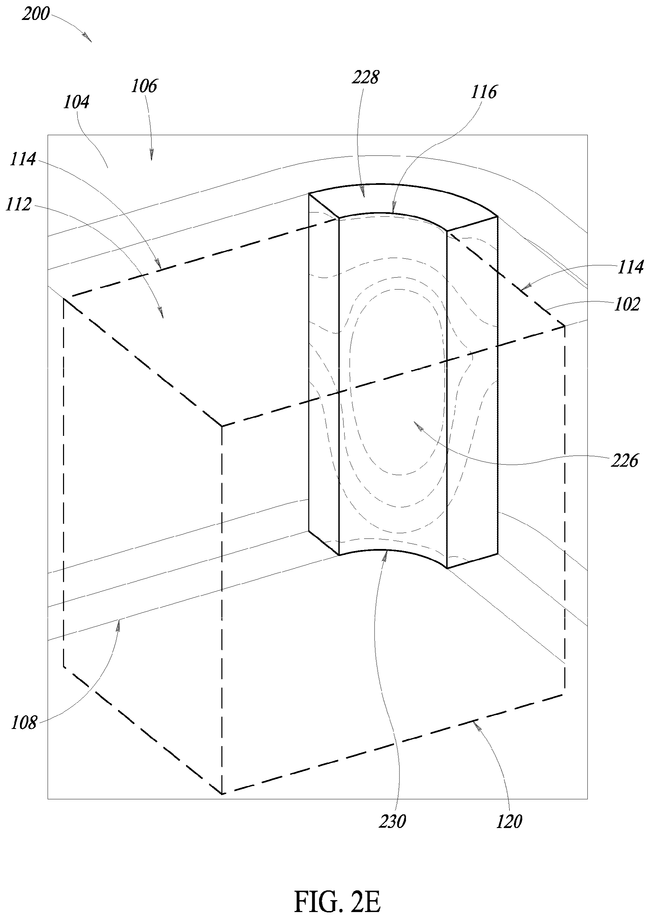

Figure 2E is a stress and strain map of section 2D-2D of the embodiment of the semiconductor package of the present disclosure as shown in Figure 2D. For ease of visibility of the stress and strain map with respect to the molding compound 1904 at or in close proximity to a respective corner of the one or more corners 116 of the conductive structure 102, the conductive structure 102 in Figure 2E is transparent and represented by dotted lines.

As shown in the stress and strain map as shown in Figure 2E, a first location 226 of maximum stress and strain is located at an intermediate point between the first surface 106 of the molding compound 104 and the second surface 108 of the molding compound 104. Based on the orientation of the semiconductor package 200 as shown in Figure 2E, the first location 226 is below the first surface 106 of the molding compound 104 and above the second surface 108 of the molding compound 104.

A second location 228 is at the first surface 106 of the molding compound 104 and a third location 230 is at the second surface of the molding compound 104. The second location 228 and the third location 230 are locations of minimal stress and strain that is less than the maximum stress and strain at the first location 226. In view of the stress and strain map as shown in Figure 2E at or in close proximity to the respective corner of the one or more corners 116 of the conductive structure 102, the stress and strain increases as one moves radially outward from the first location 226 towards the second location 228 and the third location 230.

Unlike the location 122 of maximum stress and strain as shown in Figure 1E at the first surface 106 of the molding compound 104 and at or in close proximity to the respective corner of the one or more corners 116 of the conductive structure when the semiconductor package 100 is exposed to changes in temperature or thermal energy (e.g., increases or decreases in temperature), the first location 226 of maximum stress and strain as shown in Figure 2E is between the first surface 106 and second surface 108 of the molding compound 104 and is at or in close proximity to the respective corner of the one or more corners 116 of the conductive structure 102 when the semiconductor package 200 is exposed to changes in temperature or thermal energy (e.g., increases or decreases in temperature). Unlike the location 122 being at the first surface 106 and the respective corner of the one or more corners 116 resulting in a high likelihood of mechanical defects propagating within the molding compound 104, the conductive structure 102, or both due to differences in expansion and contraction of the molding compound 104 and the conductive structure 102 in view of a CTE mismatch between them, the destressing structure 202 prevents or reduces the likelihood of mechanical defects propagating within the molding compound 104 and the conductive structure 102 as the first location 226 of maximum stress or strain is between the first surface 106 and the second surface of the molding compound 104, the second location 228 of minimal or minimized stress and strain is at the first surface 106 of the molding compound 104, and the third location 230 of minimal or minimized stress and strain is at the second surface 108 of the molding compound 104. The first location 226, the second location 228, and the third location 230 are located in this manner as discussed directly above even in view of the differences in expansion and contraction between the molding compound 104 and the conductive structure 102 caused by the CTE mismatch between them as the groove 204 of the destressing structure 202 allows for some degrees of freedom (*e.g*., bending, flexing, or some other similar or like type of degrees of freedom) for the molding compound and conductive structure to expand and contract reducing the likelihood or preventing mechanical defects from propagating within the molding compound 104 and the conductive structure 102 at an interface between the molding compound 104 and the conductive structure.

For example, when the molding compound 104 and the conductive structure 102 are exposed to an increase in temperature or thermal energy, the conductive structure 102 and the molding compound 104 expand by different amounts due to the CTE mismatch between them. As the conductive structure 102 and the molding compound 104 expand, the portion 206 of the molding compound 104 of the destressing structure 202 expands towards the groove 204 allowing for the conductive structure 102 to expand, and the second groove sidewall 212 of the molding compound 104 of the destressing structure 202 expands towards the groove 204 allowing the molding compound 104 to expand into the groove 204. However, as the portion 206 expands towards the groove 204 and the second groove sidewall 212 expands towards the groove 204, the first groove sidewall 210 and the second groove sidewall 212 do not come into contact with each other and do not abut each other due to this expansion. In other words, the groove 204 provides clearance for the conductive structure 102 and the molding compound 104 to expand while preventing a respective location of maximum stress and strain from being located at the first surface 106 of the molding compound 104 reducing the likelihood of or preventing mechanical defects from propagating within the conductive structure 102 and the molding compound at a respective location at the first surface 106, at or in close proximity to an edge 118 of the conductive structure 102, and at or in close proximity to a respective corner or the one or more corners 116 of the conductive structure 102.

For example, when the molding compound 104 and the conductive structure 102 are exposed to a decrease in temperature or thermal energy, the conductive structure 102 and the molding compound 104 contract by different amounts due to the CTE mismatch between them. As the conductive structure 102 and the molding compound 104 contract, the portion 206 of the molding compound 104 of the destressing structure 202 contracts away from the groove 204 allowing for the conductive structure 102 to contract, and the second groove sidewall 212 of the molding compound 104 of the destressing structure 202 contracts away from the groove 204 allowing the molding compound 104 to contract away from the groove 204. In other words, the groove 204 provides degrees of freedom for the conductive structure 102 and the molding compound 104 to contract while preventing a respective location of maximum stress and strain from being located at the first surface 106 of the molding compound 104 reducing the likelihood of or preventing mechanical defects from propagating within the conductive structure 102 and the molding compound at a respective location at the first surface 106, at or in close proximity to an edge 118 of the conductive structure 102, and at or in close proximity to a respective corner or the one or more corners 116 of the conductive structure 102.

In view of the above discussion, the destressing structure 202 reduces the likelihood of or prevents mechanical defects from propagating within the conductive structure 102 and the molding compound 104 when exposed to changes in temperature or thermal energy (*i.e.,* increases or decreases in temperature or thermal energy). In other words, the destressing structure 202 reduces the likelihood of or prevents points of critical stresses and strain at or along the edge 118 of the conductive structure 102, at or along the one or more corners 116 of the conductive structure 102, at or along the one or more sidewalls 114 of the conductive structure, and at or along the first surface of the molding compound 104 at which the molding compound 104 abuts (*e.g.*, interface between the molding compound 104 and the conductive structure 102) the conductive structure 102.

As shown in Figures 2A and 2B, the portion 206 extends continuously and completely around the conductive structure 102 as a unitary portion. However, in some other embodiments of the semiconductor package 200, one or more recesses may extend into the portion 206 such that the portion 206 instead includes a plurality of discrete portions that extend around the conductive structure 102.

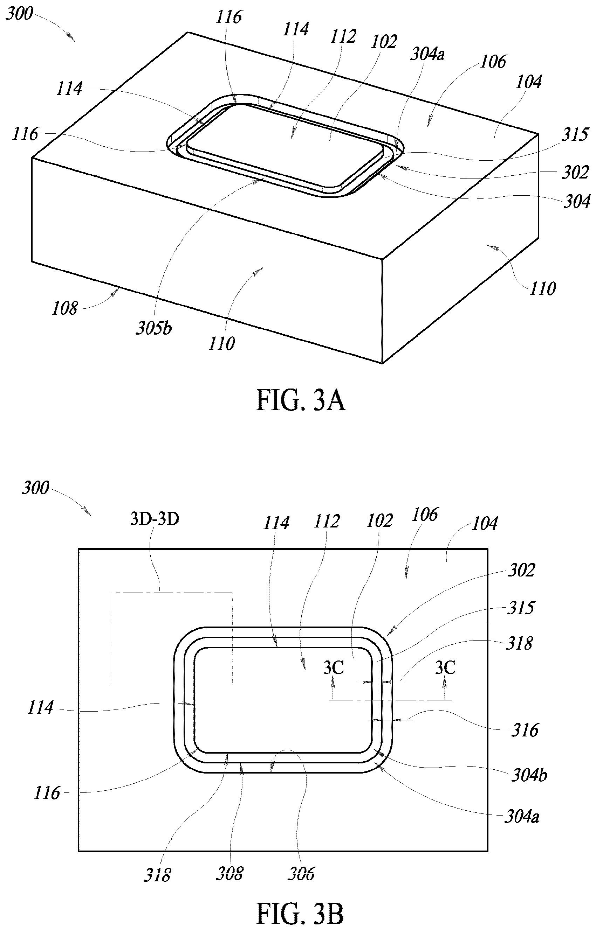

Figure 3A is a perspective view of an alternative embodiment of a semiconductor package 300 of the present disclosure. Figure 3B is a top view of the alternative embodiment of the semiconductor package 300 of the present disclosure as shown in Figure 3A.

The semiconductor package 300 includes several of the same or similar features as the semiconductor packages 100, 200, and, therefore, these same or similar features between the semiconductor packages 100, 200 and the semiconductor package 300 have been provided with the same or similar reference numerals in the semiconductor package 300. For simplicity and brevity's sake of the present disclosure, the details of these same or similar features in the semiconductor package 300 relative to the semiconductor packages 100, 200 are not necessarily reproduced herein.

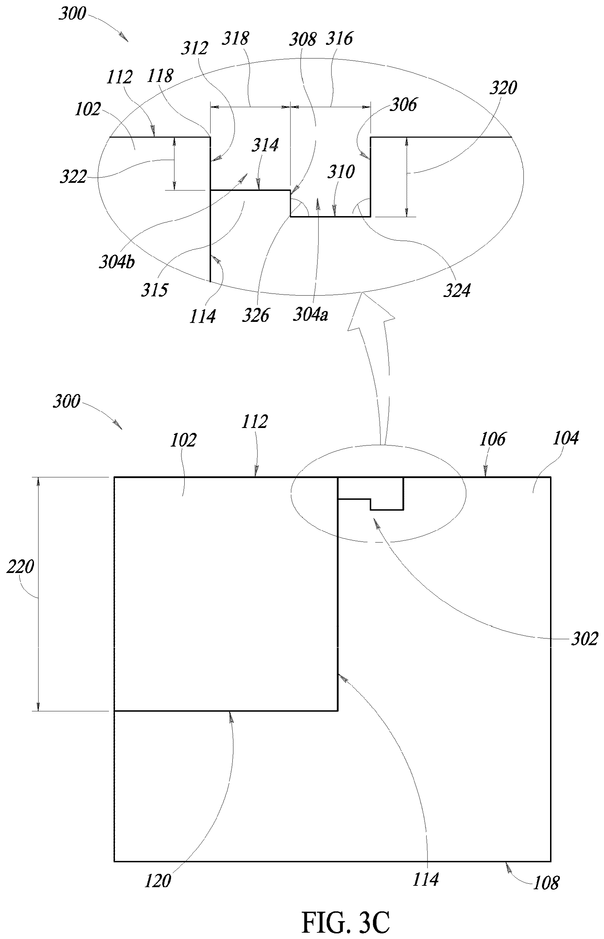

Similar to the embodiment of the semiconductor package 200 that includes the destressing structure 202, the alternative embodiment of the semiconductor package 300 includes a destressing structure 302. However, the destressing structure 302 of the semiconductor package 300 has a different structure than the destressing structure 202 of the semiconductor structure 200. The destressing structure 302 includes a groove 304, and the groove 304 includes a first groove portion 304a and a second groove portion 304b. The first groove portion 304a and the second groove portion are directly adjacent to each other, which is more readily visible in Figure 3C. In this alternative embodiment of the semiconductor package 300, the groove 304 extends completely around the edge 118 and the third surface 112 of the conductive structure 102.

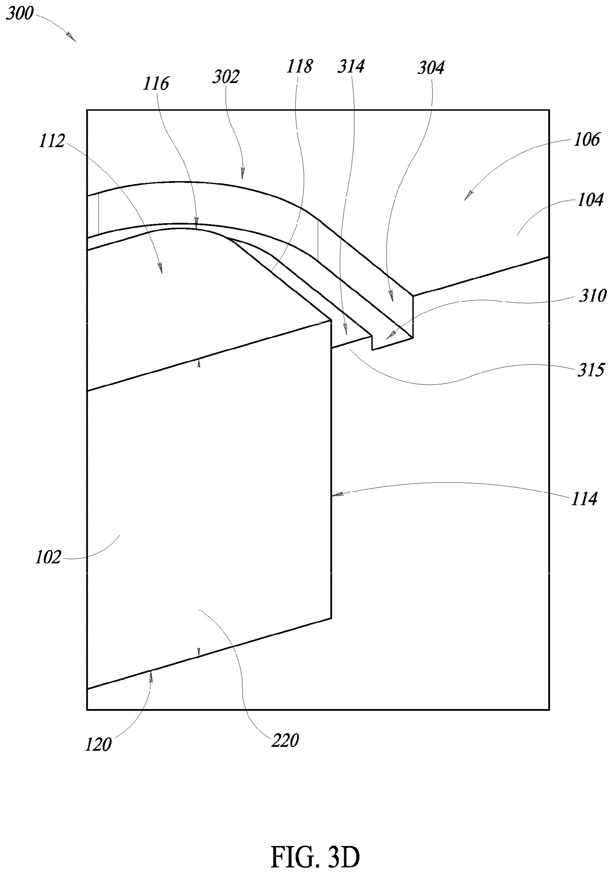

Figure 3C is a cross-sectional view of the alternative embodiment of the semiconductor package 300 of the present disclosure taken along line 3C-3C as shown in Figure 3B. Figure 3D is a cross-sectional, perspective view of the alternative embodiment of the semiconductor package of the present disclosure taken about section 3D-3D as shown in Figure 3B.

As shown in Figure 3C, the groove 304 includes the first portion 304a and the second portion 304b that are directly adjacent to each other. The first portion 304a of the groove 304 is delimited by a first groove sidewall 306 of the molding compound 104, a second groove sidewall 308 of the molding compound 104, a first end groove surface 310, and the second portion 304b of the groove 304. The second portion 304b of the groove 304 is delimited by one or more regions 312 of the one or more sidewalls 114 and the one or more corners 116 of the conductive structure 102, a second end groove surface 314 of the molding compound 104, and the first portion 304a of the groove 304. The first end groove surface 310 is transverse to the first and second groove sidewalls 306, 308, and the second end groove surface 314 is transverse to the one or more regions 312 of the one or more sidewalls 114 and the one or more corners 116 of the conductive structure 102. The second groove sidewall 308 is between the first groove sidewall 306 and the one or more regions 312. The first portion 304a and the second portion 304b of the groove 304 define or delimit a step-like structure within the groove 304. The destressing structure 302 further includes a portion 315 that extends from the first end groove surface 310 to the second end groove surface 314.

The first portion 304a of the groove 304 has a first dimension 316 that extends from the first groove sidewall 306 to the second groove sidewall 308. The second portion 304b of the groove 304 has a second dimension 318 that extends from the second groove sidewall 308 to the one or more regions 312. In this alternative embodiment of the semiconductor package 300, the first dimension 316 is larger than the second dimension 318. In some other embodiments of the semiconductor package 300, the first dimension 316 is equal to the second dimension 318 or the first dimension 316 is less than the second dimension 318. In other words, the first dimension 316 and the second dimension 318 are adjusted based on an environment in which the semiconductor package 200 is to be utilized, adjusted based on a functionality of the semiconductor package 200, or adjusted based on similar or like factors that will prevent or reduce the likelihood of mechanical defects propagating within the semiconductor package 300 due to a CTE mismatch between the conductive structure 102 and the molding compound 104.

The first portion 304a of the groove 304 has a third dimension 320 that extends from the first surface 106 of the molding compound 104 to the first end groove surface 310. The second portion 304b of the groove 304 has a fourth dimension 322 that extends from the third surface 112 of the conductive structure 102 to the second end groove surface 314. In this alternative embodiment of the semiconductor package 300, the third dimension 320 is greater than the fourth dimension 322. In some other embodiments of the semiconductor package 300, the third dimension 320 is less than the fourth dimension 322. In other words, the third dimension 320 and the fourth dimension 322 are adjusted based on an environment in which the semiconductor package 200 is to be utilized, adjusted based on a functionality of the semiconductor package 200, or adjusted based on similar or like factors that will prevent or reduce the likelihood of mechanical defects propagating within the semiconductor package 300 due to a CTE mismatch between the conductive structure 102 and the molding compound 104.

A first angle 324 is between the first groove sidewall 306 and the first end groove surface 310, and a second angle 326 is between the second groove sidewall 308 and the first end groove surface 310. In this embodiment as shown in Figure 3C, the first angle 324 and the second angle 326 are substantially equal to 90 degrees such that the first groove sidewall 306 and the second groove sidewall 308 are both perpendicular or orthogonal to the first end groove surface 310. In some other embodiments of the semiconductor package 300, the first angle 324 and the second angle 326 may be different from each other such that the first groove sidewall 306 and the second groove sidewall 308 are at different angles relative to the first end groove surface 310. The first angle 324 and the second angle 326 are adjusted based on an environment in which the semiconductor package 300 is to be utilized, adjusted based on a functionality of the semiconductor package 300, or adjusted based on similar or like factors that will prevent or reduce the likelihood of mechanical defects propagating within the semiconductor package 300 due to a CTE mismatch between the conductive structure 102 and the molding compound 104. In some other embodiments, the first angle 324 and the second angle 326 are greater than 90-degrees.

When the molding compound 104 and the conductive structure 102 are exposed to an increase in temperature or thermal energy, the conductive structure 102 and the molding compound 104 expand by different amounts due to the CTE mismatch between them. As the conductive structure 102 and the molding compound 104 expand, the portion 315 of the molding compound 104 of the destressing structure 302 expands towards the first portion 304a of the groove 304 allowing for the conductive structure 102 to expand, the second groove sidewall 308 of the molding compound 104 of the destressing structure 302 expands towards the first portion 304a of the groove 304 allowing the molding compound 104 to expand into the groove 304, and the first groove sidewall 306 expands towards the first portion 304a of the groove 304. However, as the portion 315 expands towards the first portion 304a of the groove 304, the second groove sidewall 308 expands towards the first portion 304a of the groove 304, and the first groove sidewall 306 expands towards the first portion 304a of the groove 304, the first groove sidewall 306 and the second groove sidewall 308 do not come into contact with each other and do not abut each other due to this expansion. In other words, the groove 304 provides clearance for the conductive structure 102 and the molding compound 104 to expand while preventing a respective location of maximum stress and strain from being located at the first surface 106 of the molding compound 104 reducing the likelihood of or preventing mechanical defects from propagating within the conductive structure 102 and the molding compound at a respective location at the first surface 106, at or in close proximity to an edge 118 of the conductive structure 102, and at or in close proximity to a respective corner or the one or more corners 116 of the conductive structure 102.

When the molding compound 104 and the conductive structure 102 are exposed to a decrease in temperature or thermal energy, the conductive structure 102 and the molding compound 104 contract by different amounts due to the CTE mismatch between them. As the conductive structure 102 and the molding compound 104 contract, the portion 315 of the molding compound 104 of the destressing structure 302 contracts away from the first portion 304a of the groove 304 allowing for the conductive structure 102 to contract, the second groove sidewall 308 of the molding compound 104 of the destressing structure 302 contracts away from the first portion 304a of the groove 204 allowing the molding compound 104 to contract away from the first portion 304a of the groove 304, and the first groove sidewall 306 contracts away from the first portion 304a of the groove 304. In other words, the groove 304 provides degrees of freedom for the conductive structure 102 and the molding compound 104 to contract while preventing a respective location of maximum stress and strain from being located at the first surface 106 of the molding compound 104 reducing the likelihood of or preventing mechanical defects from propagating within the conductive structure 102 and the molding compound at a respective location at the first surface 106, at or in close proximity to an edge 118 of the conductive structure 102, and at or in close proximity to a respective corner or the one or more corners 116 of the conductive structure 102.

In view of the above discussion, propagation of mechanical defects within the molding compound 104 or within the conductive structures is reduced in likelihood or prevented in view of the destressing structure 302 being within the molding compound 104. In other words, the CTE mismatch between the molding compound 104 and the conductive structure 102 is mitigated by the destressing structure 302 within the molding compound 104.

As shown in Figures 3A and 3B, the portion 315 extends continuously and completely around the conductive structure 102 as a unitary portion. However, in some other embodiments of the semiconductor package 300, one or more recesses may extend into the portion 315 such that the portion 315 instead includes a plurality of discrete portions that extend around the conductive structure 102.

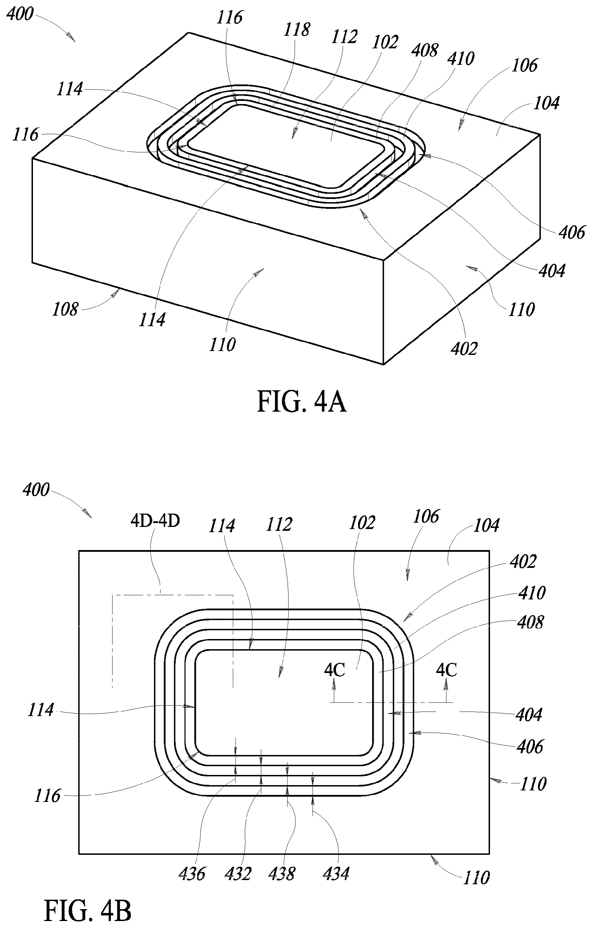

Figure 4A is a perspective view of another alternative embodiment of a semiconductor package 400 of the present disclosure. Figure 4B is a top view of the another alternative embodiment of the semiconductor package 400 of the present disclosure as shown in Figure 4A.

The semiconductor package 400 includes several of the same or similar features as the semiconductor packages 100, 200, 300, and, therefore, these same or similar features between the semiconductor packages 100, 200, 300 and the semiconductor package 400 have been provided with the same or similar reference numerals in the semiconductor package 400. For simplicity and brevity's sake of the present disclosure, the details of these same or similar features in the semiconductor package 400 relative to the semiconductor packages 100, 200, 300 are not necessarily reproduced herein.

Similar to the embodiment of the semiconductor packages 200, 300 that include the destressing structures 202, 302, the another alternative embodiment of the semiconductor package 400 includes a destressing structure 402. However, the destressing structure 402 of the semiconductor package 400 includes a first groove 404 and a second groove 406. The first groove 404 is closer to the conductive structure 102 than the second groove 406, the first groove 404 is between the conductive structure 102 and the second groove 406, and the first groove extends completely around the third surface 112 of the conductive structure 102. The second groove extends completely around the third surface 112 of the conductive structure 102 and extends completely around the first groove 404.

The destressing structure 402 further includes a first portion or wall 408 that extends from the conductive structure 102 to the first groove 404. The first portion 408 extends completely around the third surface 112 of the conductive structure 102 and separates the first groove 404 from the conductive structure 102. The destressing structure further includes a second portion or wall 410 that extends from the first groove 404 to the second groove 406. The second portion 410 extends completely around the third surface 112 of the conductive structure 102 and extends completely around the first groove 404. The second portion 410 is between the first groove 404 and the second groove 406 and completely separates the first groove 404 from the second groove 406.

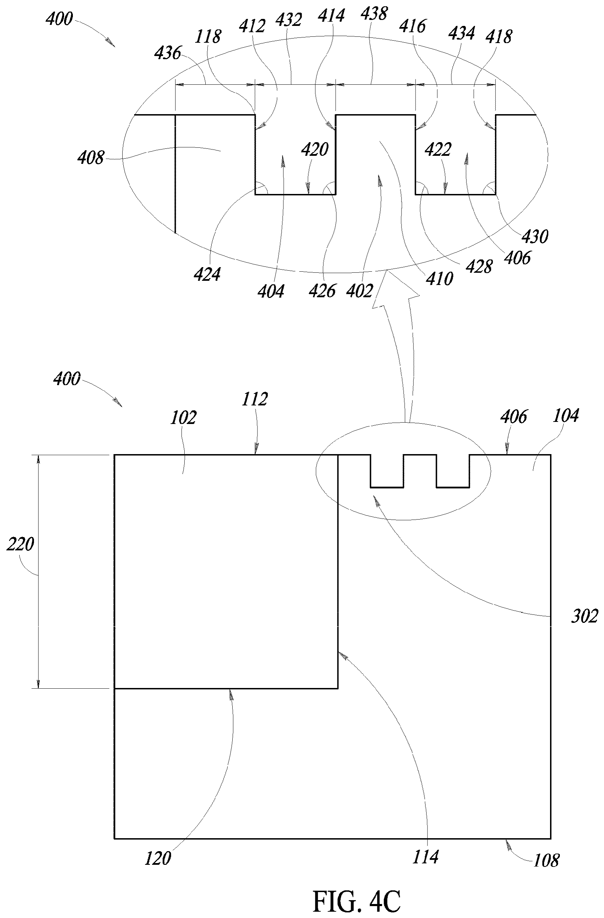

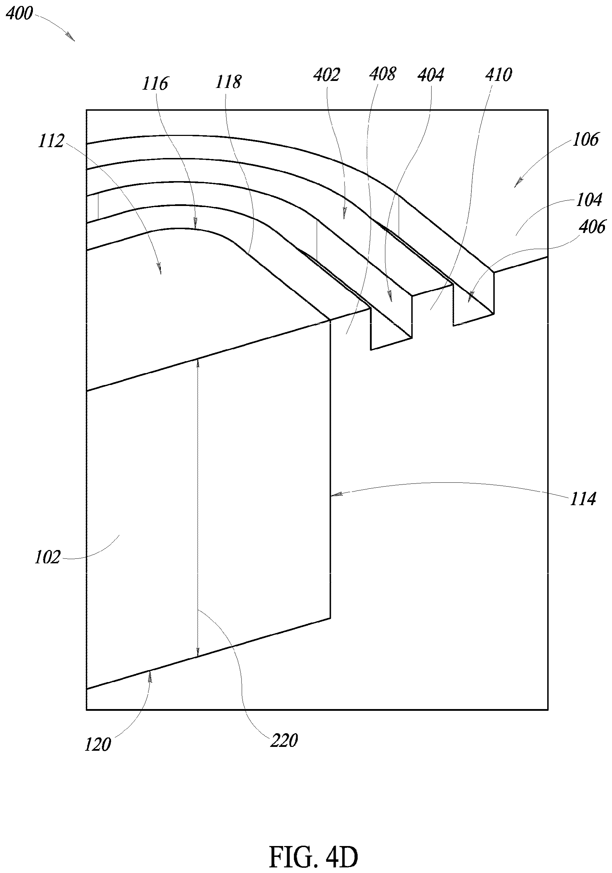

Figure 4C is a cross-sectional view of the another alternative embodiment of the semiconductor package 400 of the present disclosure taken along line 4C-4C as shown in Figure 4B. Figure 4D is a cross-sectional, perspective view of the another alternative embodiment of the semiconductor package 400 of the present disclosure taken about section 4D-4D as shown in Figure 4B.

As shown in Figure 4C, the first portion 408 includes a first groove sidewall 412, the second portion 410 includes a second groove sidewall 414 and a third groove sidewall 416, and the molding compound 104 further includes a fourth groove sidewall 418, a first end groove surface 420, and a second end groove surface 422. The first groove 404 is delimited and defined by the first groove sidewall 412, the first end groove surface 420, and the second groove sidewall 414, and the second groove 406 is delimited and defined by the third groove sidewall 416, the fourth groove sidewall 418, and the second end groove surface 422. The first end groove surface 420 is transverse to the first groove sidewall 412 and the second groove sidewall 414, and the second end groove surface 422 is transverse to the third groove sidewall 416 and the fourth groove sidewall 418.

The first groove sidewall 412 is at a first angle 424 relative to the first end groove surface 420, and the second groove sidewall 414 is at a second angle 426 relative to the first end groove surface 420. The third groove sidewall 416 is at a third angle 428 relative to the second end groove surface 422, and the fourth groove sidewall 418 is at a fourth angle 430 relative to the second end groove surface 422. In this embodiment of the semiconductor package 400 as shown in Figure 4C, the first, second, third, and fourth angles 424, 426, 428, 430 are substantially equal to 90-degrees such that the first, second, third, and fourth groove sidewalls 412, 414, 416, 418 are substantially perpendicular or orthogonal to, respectively, the first end groove surface 420 and the second end groove surface 422. In some other embodiments of the semiconductor package 400, the first, second, third, and fourth angles 424, 426, 428, 430 may be different from each other such that the first, second, third, and fourth groove sidewalls 412, 414, 416, 418 are at different angles relative to the first groove end surface 420 and the second groove end surface 422, respectively. The first, second, third, and fourth angles 424, 426, 428, 430 are adjusted based on an environment in which the semiconductor package 400 is to be utilized, adjusted based on a functionality of the semiconductor package 400, or adjusted based on similar or like factors that will prevent or reduce the likelihood of mechanical defects propagating within the semiconductor package 400 due to a CTE mismatch between the conductive structure 102 and the molding compound 104. In some other embodiments, the first, second, third, and fourth angles 424, 426, 428, 430 are greater than 90-degrees.

The first groove 404 has a first dimension 432 that extends from the first groove sidewall 412 to the second groove sidewall 414. The second groove 406 has a second dimension 434 that extends from the third groove sidewall 416 to the fourth groove sidewall 418. The first portion 408 has a third dimension 436 that extends from the conductive structure 102 (*e.g.,* the one or more corners 116 or the one or more sidewalls 114 of the conductive structure 102) to the first groove sidewall. The second portion 410 has a fourth dimension 438 that extends from the second groove sidewall 414 to the third groove sidewall 416. In this embodiment of the semiconductor package 400, the first and second dimensions 432, 434 are substantially equal to each other, and the third dimension 436 is less than the fourth dimension 438. The first, second, third, and fourth dimensions 432, 434, 436, 438 are adjusted based on an environment in which the semiconductor package 400 is to be utilized, adjusted based on a functionality of the semiconductor package 400, or adjusted based on similar or like factors that will prevent or reduce the likelihood of mechanical defects propagating within the semiconductor package 400 due to a CTE mismatch between the conductive structure 102 and the molding compound 104. In some other embodiments, the first, second, third, and fourth dimensions 432, 434, 436, 438 are all equal to each other. In some other embodiments, the first, second, third, and fourth dimensions 432, 434, 436, 438 are all different from each other. In some other embodiments, the first, second, third, and fourth dimensions 432, 434, 436, 438 may have varying combinations of dimension such that some are equal to each other and some are different from each other, respectively.

When the molding compound 104 and the conductive structure 102 are exposed to an increase in temperature or thermal energy, the conductive structure 102 and the molding compound 104 expand by different amounts due to the CTE mismatch between them. As the conductive structure 102 and the molding compound 104 expand, the portion 315 of the molding compound 104 of the destressing structure 302 expands towards the first portion 304a of the groove 304 allowing for the conductive structure 102 to expand, the second groove sidewall 308 of the molding compound 104 of the destressing structure 302 expands towards the first portion 304a of the groove 304 allowing the molding compound 104 to expand into the groove 304, and the first groove sidewall 306 expands towards the first portion 304a of the groove 304. However, as the portion 315 expands towards first portion 304a of the groove 304, the second groove sidewall 308 expands towards the first portion 304a of the groove 304, and the first groove sidewall 306 expands towards the first portion 304a of the groove 304, the first groove sidewall 306 and the second groove sidewall 308 do not come into contact with each other and do not abut each other due to this expansion. In other words, the groove 304 provides clearance for the conductive structure 102 and the molding compound 104 to expand while preventing a respective location of maximum stress and strain from being located at the first surface 106 of the molding compound 104 reducing the likelihood of or preventing mechanical defects from propagating within the conductive structure 102 and the molding compound at a respective location at the first surface 106, at or in close proximity to an edge 118 of the conductive structure 102, and at or in close proximity to a respective corner or the one or more corners 116 of the conductive structure 102.

When the molding compound 104 and the conductive structure 102 are exposed to an increase in temperature or thermal energy, the conductive structure 102 and the molding compound 104 expand by different amounts due to the CTE mismatch between them. As the conductive structure 102 and the molding compound 104 expand, the first portion 408 of the molding compound 104 of the destressing structure 402 expands towards the first groove 404 allowing for the conductive structure 102 to expand, the second groove sidewall 414 of the second portion 410 of the destressing structure 402 expands towards the first groove 404 allowing the molding compound 104 to expand into the first groove 404, the third groove sidewall 416 of the second portion 410 expands towards the second groove 406, and the fourth groove sidewall 418 of the molding compound 104 expands towards the second groove 406. However, as these respective sidewalls and portions of the molding compound 104 expand towards the first groove 404 and the second groove 406 within the molding compound 104, respectively, these respective sidewalls and portions of the molding compound 104 do not come into contact with each other and do not abut each other due to this expansion. In other words, the first and second grooves 404, 406 provide clearance for the conductive structure 102 and the molding compound 104 to expand while preventing a respective location of maximum stress and strain from being located at the first surface 106 of the molding compound 104 reducing the likelihood of or preventing mechanical defects from propagating within the conductive structure 102 and the molding compound 104 at a respective location at the first surface 106, at or in close proximity to an edge 118 of the conductive structure 102, and at or in close proximity to a respective corner or the one or more corners 116 of the conductive structure 102.

When the molding compound 104 and the conductive structure 102 are exposed to a decrease in temperature or thermal energy, the conductive structure 102 and the molding compound 104 contract by different amounts due to the CTE mismatch between them. As the conductive structure 102 and the molding compound 104 contract, the first portion 408 of the molding compound 104 of the destressing structure 402 contracts away from the first groove 404 allowing for the conductive structure 102 to contract, the second groove sidewall 414 of the second portion 410 of the molding compound 104 of the destressing structure 402 contracts away from the first groove 404 allowing the molding compound 104 to contract away from the first groove 404, the third groove sidewall 416 contracts away from the second groove 406, and the fourth groove sidewall 418 contracts away from the second groove 406. In other words, the first and second grooves 404, 406 provide degrees of freedom for the conductive structure 102 and the molding compound 104 to contract while preventing a respective location of maximum stress and strain from being located at the first surface 106 of the molding compound 104 reducing the likelihood of or preventing mechanical defects from propagating within the conductive structure 102 and the molding compound at a respective location at the first surface 106, at or in close proximity to an edge 118 of the conductive structure 102, and at or in close proximity to a respective corner or the one or more corners 116 of the conductive structure 102.

In view of the above discussion, propagation of mechanical defects within the molding compound 104 or within the conductive structures is reduced in likelihood or prevented in view of the destressing structure 402 being within the molding compound 104. In other words, the CTE mismatch between the molding compound 104 and the conductive structure 102 is mitigated by the destressing structure 402 within the molding compound 104.

As shown in Figures 4A and 4B, the first portion 408 and the second portion 410 extends continuously and completely around the conductive structure 102 as a unitary portion. However, in some other embodiments of the semiconductor package 400, one or more recesses may extend into the first portion 408 and the second portion 410 such that the first portion 408 and the second portion 410 include a plurality of discrete portions and such that the first groove 404 is in fluid communication with the second groove 406 through the one or more recesses.

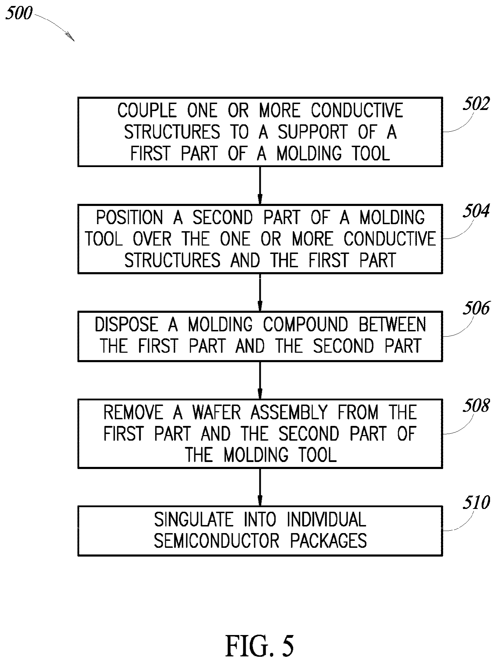

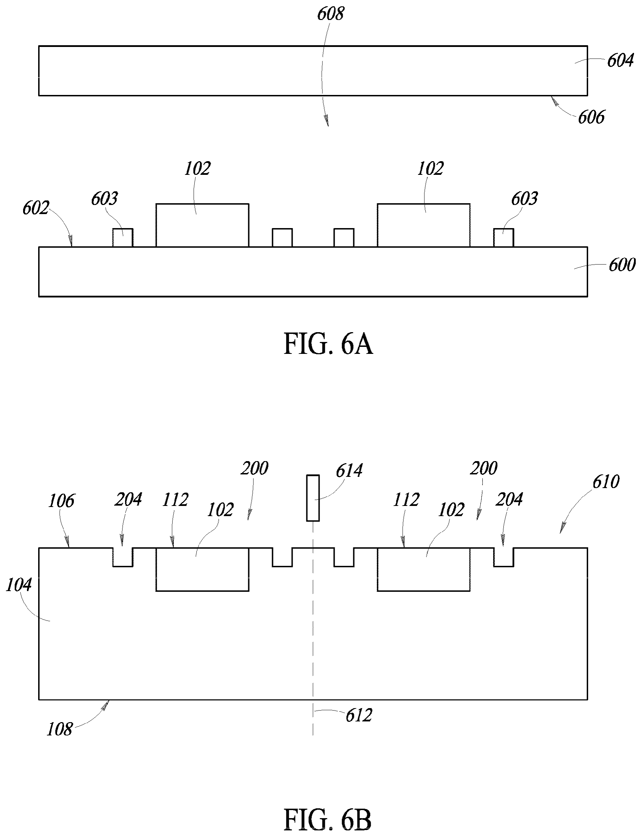

Figure 5 is a flowchart 500 of an embodiment of a method of manufacturing the destressing structure 202 of the embodiment of the semiconductor package 200 as shown in Figures 2A-2D of the present disclosure. Figures 6A and 6B are cross-sectional side views of respective steps of the method of manufacturing as shown in Figure 5. The flowchart 500 includes a first step 502, a second step 504, a third step 506, a fourth step 508, and a fifth step 510.

In the first step 502, one or more of the conductive structures 102 are coupled to a first part 600 of a mold tool. The results of the one or more of the conductive structures 102 that are coupled to the first part 600 of the mold tool are readily visible in Figure 6A. As shown in Figure 6A, one or more of the conductive structures 102, which may be heat sinks, electrical structures utilized to form electrical connections within a semiconductor device, contact pads to provide electrical access to electrical components within a semiconductor device, or some other similar or like type of conductive structure that is utilized within a semiconductor device, are coupled to a surface 602 of the first part 600 of the mold tool. The first part 600 of the mold tool further includes one or more protrusion structures 603 that protrude outward form the surface 602 of the first part 600. The one or more protrusion structures 603 are ring-shaped structures that extend continuously and completely around the conductive structures 102. In other words, each respective conductive structure of the one or more conductive structures 102 is placed within a corresponding one of the one or more protrusion structures 603, which have a ring-shape that mirrors the groove 204 of the embodiment of the semiconductor package 200 of the present disclosure.

In a second step 504, a second part 604 of the mold tool is positioned to overlap the first part 600 of the mold tool and to overlap the conductive structures 102 coupled to the first part 600 of the mold tool. Once the second part 604 is positioned, the surface 602 of the first part 600 and an opposing surface 606 of the second part 604 of the mold tool define a channel, cavity, or open region 608 into which the molding compound 104 will be disposed.

In a third step 506, the molding compound 104 is disposed between the surface 602 of the first part 600 of the mold tool and the opposing surface 606 of the second part 604 of the mold tool. The molding compound 104 is allowed to cure at least enough such that the conductive structures 102 are held within the molding compound 104 and such that the grooves 204 are formed within the molding compound 104.

In a fourth step 508, a wafer assembly 610 is removed from the first part 600 and the second part 604 of the mold tool. The results of removing the wafer assembly 610 from the first part 600 and the second part 604 of the mold tool are readily visible in Figure 6B. Furthermore, once the wafer assembly 610 is removed from the first part 600 and the second part 604 of the mold tool, the grooves 204 within the molding compound 104 have been formed, and each respective groove of the grooves 204 extends continuously and completely around a corresponding one of the conductive structures 102.

In a fifth step 510, the wafer assembly 610 is singulated into individual ones of the semiconductor packages 200. The wafer assembly 610 is singulated along cutting locations as represented by line 612. The wafer assembly 610 may be cut at these cutting locations with a cutting tool 614, a sawing tool, a laser tool, or some other similar or like type of singulation tool suitable for singulating the wafer assembly 610 into individual ones of the semiconductor packages 200.

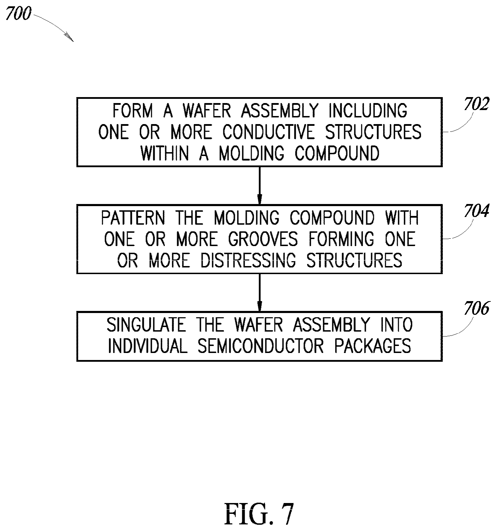

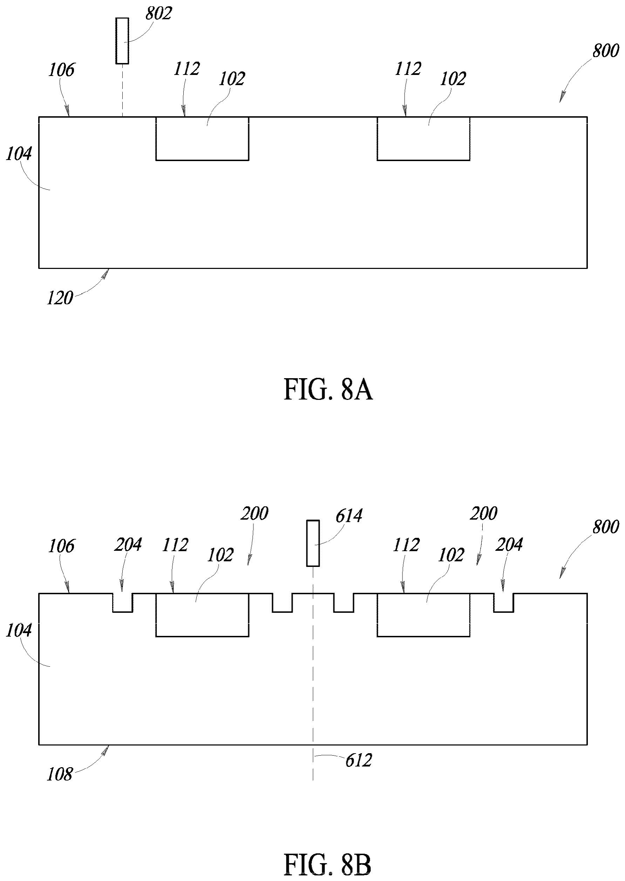

Figure 7 is a flowchart 700 of an alternative embodiment of a method of manufacturing the destressing structure 202 of the embodiment of the semiconductor package 200 as shown in Figures 2A-2D of the present disclosure. Figures 8A and 8B are cross-sectional side views of respective steps of the method of manufacturing as shown in Figure 7. The flowchart 700 includes a first step 702, a second step 704, and a third step 706.

In the first step, a wafer assembly 800 has previously been formed. The wafer assembly 800 may be formed by utilizing steps similar to the first, second, third, and fourth steps 502, 504, 506, 508 of the flowchart 500 as described earlier herein in detail. However, when forming the wafer assembly 800 as shown in Figure 8A, the first part 600 of the mold tool does not include the protrusion structures 603 such that the grooves 204 are not formed by disposing the molding compound 104 between the first part 600 and the second part 604 of the mold tool.

In a second step 704, the molding compound 104 of the wafer assembly 800 is patterned utilizing a laser tool 802. For example, as shown in Figure 8A, the laser tool 802 directs a laser at the first surface 106 of the molding compound 104 removing portions of the molding compound 104 as the laser tool 802 moves along the first surface 106 forming the grooves 204 around the conductive structures 102 within the molding compound 104. Alternatively, a stencil or pattern may be applied to or made to overlap the first surface 106 of the molding compound 104 and the third surfaces 112 of the conductive structures 102. The stencil is patterned with openings that allow for a laser to pass through the openings such that several portions of the molding compound 104 are removed simultaneously essentially forming the grooves 204 around each of the conductive structures 102 being formed simultaneously.

In a third step 706, the wafer assembly 800 with the grooves 204 now formed in the molding compound 104 is singulated into individual ones of the semiconductor package 200. The third step 706 is carried out in the same or similar fashion as the fifth step 510 of the flowchart 500.

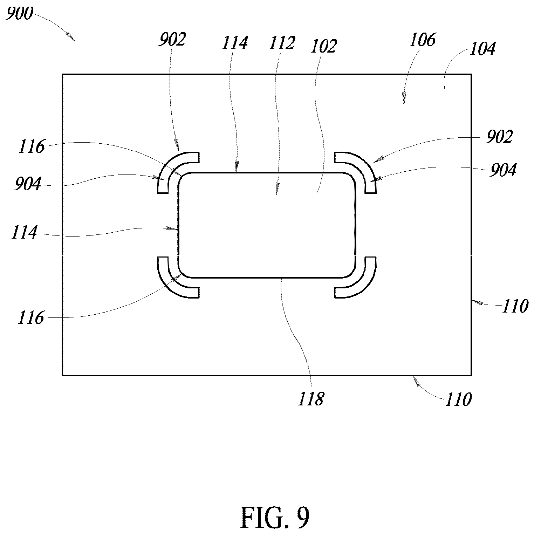

Figure 9 is a top view of yet another alternative embodiment of a semiconductor package 900 of the present disclosure. The semiconductor package 900 includes a plurality of destressing structures 902 each including a corresponding groove 904. In other words, the molding compound 104 includes the plurality of destressing structures 902, and each respective destressing structure of the plurality of destressing structures 902 is separate, distinct, and discrete from each other. Each respective groove of the plurality of grooves 904 is positioned at a corresponding corner of the one or more corners 116 of the conductive structure 102. In view of Figure 9, unlike the semiconductor packages 200, 300, 400 that include destressing structures 202, 302, 402 that extend continuously and completely around the conductive structure 102, the plurality of destressing structures 902 is present at selected locations along and directly adjacent or in close proximity to the one or more corners 116 of the conductive structure 102, and the plurality of destressing structures 902 is discontinuous and discrete from each other. In some other embodiments of the semiconductor package 900, the locations at which the plurality of destressing structures 902 is located may be selected to be located along the one or more sidewalls 114 of the conductive structure. In yet some other embodiments of the semiconductor package 900, the plurality of destressing structures 902 may be selected to be located at or in close proximity to any points along the edge 118 of the conductive structures 102 that may be critical points of maximum stress and strain when the semiconductor package 900 is exposed to changes in temperature or thermal energy (*i.e.,* increases in temperature or thermal energy and decreases in temperature or thermal energy).

In view of the above discussion, the present disclosure is directed to providing one or more embodiments of destressing structures 202, 302, 402, 902 that are formed within the molding compound 104 to reduce stresses and strains that propagate within the molding compound 104, within the conductive structure 102, or between the molding compound 104 and the conductive structure 102 to reduce the likelihood of or prevent mechanical defects from propagating within the molding compound 104, the conductive structure 102, or between the molding compound 104 and the conductive structure 102. These respective embodiments of the destressing structures 202, 302, 402, 902 are readily visible in the embodiments of the semiconductor packages 200, 300, 400, 900 of the present disclosure

An embodiment of a device of the present disclosure may be summarized as including: a molding compound including a first surface; a conductive structure within the molding compound, the conductive structure including a second surface exposed from the first surface; and a destressing structure of the molding compound, the destressing structure including: a first groove extending into the first surface of the molding compound, the first groove extending at least partially around the second surface of the conductive structure.

The groove may extend fully around the second surface of the conductive structure.

The conductive structure may further include a sidewall transverse to the second surface of the conductive structure; the first groove may be directly adjacent to the sidewall of the conductive structure and may expose a first region of the sidewall of the conductive structure; and the molding compound may be directly adj acent to the sidewall of the conductive structure and may cover a second region of the sidewall of the conductive structure.

The first groove may include: a first portion with a first depth directly adjacent to the sidewall of the conductive structure, the first portion exposing the first region of the sidewall of the conductive structure; and a second portion with a second depth directly adjacent to the first portion, the second depth being greater than the first depth, and the second portion being separated from the sidewall of the conductive structure by the first portion.

The first portion may have a first width; and the second portion may have a second width that is greater than the first width.

The first portion may have a first width; and the second portion may have a second width that is different than the first width.

An embodiment of a method of the present disclosure may be summarized as including: forming a molding compound on a sidewall of a conductive structure and exposing a first surface of the conductive structure transverse to the sidewall of the conductive structure from a second surface of the molding compound; and forming a destressing structure within the molding compound, forming the destressing structure includes: forming a first groove extending into second surface of the molding compound and extending at least partially around the first surface of the conductive structure.

Forming the first groove may include utilizing a laser.

Forming the destressing structure within the molding compound may occur when forming the molding compound by utilizing a molding compound tool patterned with respective portions corresponding to the destressing structure.

The method may further include forming a second groove extending into the second surface of the molding compound, and the second groove being spaced apart from the first groove.

An embodiment of a device of the present disclosure may be summarized as including: a molding compound including a first surface; a conductive structure within the molding compound, the conductive structure including a second surface exposed from the first surface; and a destressing structure of the molding compound, the destressing structure including: a first groove extending into the first surface of the molding compound, the first groove extending at least partially around the second surface of the conductive structure; and a second groove extending into the first surface of the molding compound, the second groove extending at least partially around the second surface of the conductive structure, and the second groove being in closer proximity to the second surface of the conductive structure than the first groove.

The conductive structure may include a sidewall transverse to the second surface of the conductive structure; and the second groove may be between the sidewall of the conductive structure and the first groove.

The destressing structure may further include a second groove that extends into the first surface of the molding compound, the second groove may extend at least partially around the second surface of the conductive structure, and the second groove may be between the first groove and the conductive structure.

The first groove and the second groove may extend fully around the second surface of the conductive structure.

The first groove may have a first depth; and the second groove may have a second depth substantially equal to the first depth.

The first groove may have a first depth; and the second groove may have a second depth different from the first depth.

The destressing structure may further include a protrusion portion of the molding compound that is between the first groove and the second groove.

The protrusion portion may fully separate the first groove from the second groove.

The conductive structure may include a sidewall transverse to the second surface of the conductive structure; and the second groove may be offset from the sidewall of the conductive structure.

The conductive structure may include a sidewall transverse to the second surface of the conductive structure; the second groove may be directly adjacent to the sidewall of the conductive structure and may expose a first region of the sidewall of the conductive structure; and the molding compound may cover a second region of the sidewall of the conductive structure.

The various embodiments described above can be combined to provide further embodiments. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A device, comprising:
a molding compound including a first surface;
a conductive structure within the molding compound, the conductive structure including a second surface exposed from the first surface; and
a destressing structure of the molding compound, the destressing structure including:
a first groove extending into the first surface of the molding compound, the first groove extending at least partially around the second surface of the conductive structure.

2. The device of claim 1, wherein the groove extends fully around the second surface of the conductive structure.

3. The device of claim 1, wherein:
the conductive structure further includes a sidewall transverse to the second surface of the conductive structure;
the first groove is directly adjacent to the sidewall of the conductive structure and exposes a first region of the sidewall of the conductive structure; and
the molding compound is directly adjacent to the sidewall of the conductive structure and covers a second region of the sidewall of the conductive structure.

4. The device of claim 3, wherein the first groove includes:
a first portion with a first depth directly adjacent to the sidewall of the conductive structure, the first portion exposing the first region of the sidewall of the conductive structure; and
a second portion with a second depth directly adjacent to the first portion, the second depth being greater than the first depth, and the second portion being separated from the sidewall of the conductive structure by the first portion.

5. The device of claim 4, wherein:
the first portion has a first width; and
the second portion has a second width that is greater than the first width.

6. The device of claim 4, wherein:
the first portion has a first width; and
the second portion has a second width that is different than the first width.

7. A method, comprising:
forming a molding compound on a sidewall of a conductive structure and exposing a first surface of the conductive structure transverse to the sidewall of the conductive structure from a second surface of the molding compound; and
forming a destressing structure within the molding compound, forming the destressing structure includes:
forming a first groove extending into second surface of the molding compound and extending at least partially around the first surface of the conductive structure.

8. The method of claim 7, wherein forming the first groove includes utilizing a laser.

9. The method of claim 7, wherein forming the destressing structure within the molding compound occurs when forming the molding compound by utilizing a molding compound tool patterned with respective portions corresponding to the destressing structure.

10. The method of claim 7, further comprising forming a second groove extending into the second surface of the molding compound, and the second groove being spaced apart from the first groove.

11. A device, comprising:
a molding compound including a first surface;
a conductive structure within the molding compound, the conductive structure including a second surface exposed from the first surface; and
a destressing structure of the molding compound, the destressing structure including:
a first groove extending into the first surface of the molding compound, the first groove extending at least partially around the second surface of the conductive structure; and
a second groove extending into the first surface of the molding compound, the second groove extending at least partially around the second surface of the conductive structure, and the second groove being in closer proximity to the second surface of the conductive structure than the first groove.

12. The device of claim 11, wherein:
the conductive structure includes a sidewall transverse to the second surface of the conductive structure; and
the second groove is between the sidewall of the conductive structure and the first groove.

13. The device of claim 11, wherein the destressing structure further includes a second groove that extends into the first surface of the molding compound, the second groove extends at least partially around the second surface of the conductive structure, and the second groove is between the first groove and the conductive structure.

14. The device of claim 11, wherein the first groove and the second groove extend fully around the second surface of the conductive structure.

15. The device of claim 11, wherein:
the first groove has a first depth; and
the second groove has a second depth substantially equal to the first depth.

16. The device of claim 11, wherein:
the first groove has a first depth; and
the second groove has a second depth different from the first depth.

17. The device of claim 11, wherein the destressing structure further includes a protrusion portion of the molding compound that is between the first groove and the second groove.

18. The device of claim 17, wherein the protrusion portion fully separates the first groove from the second groove.

19. The device of claim 11, wherein:
the conductive structure includes a sidewall transverse to the second surface of the conductive structure; and
the second groove is offset from the sidewall of the conductive structure.

20. The device of claim 11, wherein:
the conductive structure includes a sidewall transverse to the second surface of the conductive structure;
the second groove is directly adjacent to the sidewall of the conductive structure and exposes a first region of the sidewall of the conductive structure; and
the molding compound covers a second region of the sidewall of the conductive structure.
